(19) Europäisches Patentamt
European Patent Office
Office européen des brevets

(11) **EP 3 035 017 B1**

(12) **FASCICULE DE BREVET EUROPEEN**

(45) Date de publication et mention
de la délivrance du brevet:
**27.09.2017 Bulletin 2017/39**

(21) Numéro de dépôt: **15201736.4**

(22) Date de dépôt: **21.12.2015**

(51) Int Cl.:
*G01K 1/08* *(2006.01)*       *G01K 1/18* *(2006.01)*
*G01K 7/02* *(2006.01)*       *G01K 17/20* *(2006.01)*

(54) **CAPTEUR DIFFERENTIEL DE TEMPERATURE**

**DIFFERENZIELLER TEMPERATURSENSOR**

**DIFFERENTIAL TEMPERATURE SENSOR**

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **19.12.2014 FR 1462971**

(43) Date de publication de la demande:
**22.06.2016 Bulletin 2016/25**

(73) Titulaires:
• **Commissariat à l'Energie Atomique et aux
Energies
Alternatives
75015 Paris (FR)**
• **Hotblock Onboard
38000 Grenoble (FR)**

(72) Inventeurs:
• **Savelli, Guillaume
38180 Seyssins (FR)**
• **Dufourcq, Joël
64270 Puyoo (FR)**

(74) Mandataire: **Talbot, Alexandre et al
Cabinet Hecké
Europole
10, rue d'Arménie - BP 1537
38025 Grenoble Cedex 1 (FR)**

(56) Documents cités:
**EP-A1- 1 767 913**

• **SEOK HWAN OH ET AL: "Micro heat flux sensor
using copper electroplating in SU-8
microstructures; Micro heat flux sensor using
copper electroplating", JOURNAL OF
MICROMECHANICS & MICROENGINEERING,
INSTITUTE OF PHYSICS PUBLISHING, BRISTOL,
GB, vol. 11, no. 3, 1 mai 2001 (2001-05-01), pages
221-225, XP020068639, ISSN: 0960-1317, DOI:
10.1088/0960-1317/11/3/310**
• **KIMBER T: "ENERGY EFFICIENCY ENSURED
THROUGH SURFACE TEMPERATURE AND
HEAT FLOW STUDIES", STRAIN, BLACKWELL
PUBLISHING LTD., MALDEN, MA, US, vol. 26, no.
2, 1 mai 1990 (1990-05-01), pages 67-69,
XP000136420, ISSN: 0039-2103**

## Description

## Domaine technique

La présente invention a trait à un capteur différentiel de température. Plus précisément, il s'agit d'un capteur thermoélectrique à effet Seebeck. La présente invention a trait également à un dispositif de mesure différentielle de température comportant une pluralité de tels capteurs.

## Etat de la technique antérieure

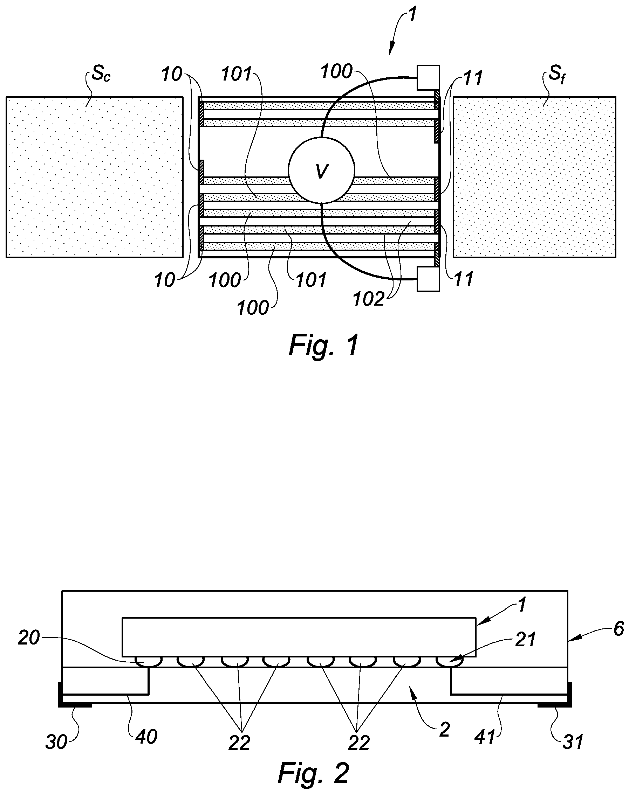

Comme illustré à la figure 1, un capteur 1 différentiel de température entre une source chaude Sc et une source froide Sf connu de l'état de la technique, comporte :

- un substrat (non visible), de préférence réalisé dans un matériau à base de silicium,
- un ensemble de couches thermoélectriques agencé sur le substrat séparées par un matériau thermiquement isolant 102, l'ensemble comprenant au moins une première jonction 10 d'un thermocouple 100, 101 sur un côté de l'ensemble, dit côté chaud, et au moins une deuxième jonction 11 du thermocouple 100, 101 sur le côté opposé de l'ensemble, dit côté froid,
- au moins un premier et un deuxième plots de connexion (non visibles) agencés pour transférer de la chaleur respectivement à chaque première jonction 10 et à chaque deuxième jonction 11.

Les termes « chaud(e) » et « froid(e) » s'entendent de manière relative, c'est-à-dire que la température de la source « chaude » est supérieure à la température de la source « froide ».

Les plots de connexion sont destinés à être connectés thermiquement à la source chaude Sc et à la source froide Sf.

L'ensemble de couches thermoélectriques comporte N thermocouples 100, 101, c'est-à-dire N couches réalisées à base d'un premier matériau thermoélectrique 100 et N couches réalisées à base d'un second matériau thermoélectrique 101. Chaque première jonction 10 et chaque deuxième jonction 11 sont formées avec un matériau électriquement conducteur.

La tension de sortie V générée par le capteur 1 est donnée par la formule suivante :

$$V = N \times (S_2 - S_1) \times (T_c - T_f),$$

où :

- N est le nombre de thermocouples 100, 101,
- $S_1$ et $S_2$ sont respectivement le coefficient Seebeck des premier et second matériaux thermoélectriques 100, 101,
- $(T_c - T_f)$ est le gradient thermique appliqué entre le côté chaud et le côté froid de l'ensemble.

Un tel capteur 1 de l'état de la technique forme une puce, et s'inscrit dans les technologies couches minces, différant ainsi des capteurs thermoélectriques à effet Seebeck macroscopiques.

Par « puce », on entend une plaquette, de préférence en silicium, comportant un composant élémentaire.

Un tel capteur 1 de l'état de la technique est donc utilisé dans diverses applications où la miniaturisation est recherchée. On peut citer à titre d'exemples non limitatifs la microélectronique, la téléphonie mobile, la domotique (maison communicante individuelle « *Smart home »,* bâtiment à énergie positive « *Smart building* », réseaux électriques intelligents *« Smart grid* »), certains procédés industriels.

Par ailleurs, des capteurs planaires non intégrés pouvant effectuer des mesures de température d'un flux orthogonal au substrat sont connus de l'état de la technique, notamment des documents WO 2007034048, FR 2955708, WO 8402037, FR 2598803 et dans "Micro heat flux sensor using copper electroplating in SU-8 microstructures" par Seok Hwan Oh et al, publié dans le Journal of Micromechanics and Microengineering, 11 (2001) pp.221-225. Actuellement, pour réaliser une fonction électronique, l'intégration d'un tel capteur 1 à d'autres composants élémentaires dans un circuit s'effectue lors du procédé technologique de fabrication du circuit. Cette solution n'est pas satisfaisante car elle occasionne une complexité et de multiples contraintes pour l'exécution des étapes du procédé qui doivent tenir compte de l'influence des composants élémentaires adjacents.

En outre, l'intégration directe d'un tel capteur 1 dans un boîtier, par exemple un boîtier de circuit intégré, occasionne des pertes thermiques importantes qui affectent le gradient thermique appliqué entre le côté chaud et le côté froid de l'ensemble, empêchant ainsi le fonctionnement correct du capteur 1.

## Exposé de l'invention

La présente invention vise à remédier en tout ou partie aux inconvénients précités, et concerne à cet effet un capteur différentiel de température entre une source chaude et une source froide, le capteur comportant un substrat, un ensemble de couches thermoélectriques agencé sur le substrat, l'ensemble comprenant au moins une première jonction d'un thermocouple sur un côté de l'ensemble, dit côté chaud, et au moins une deuxième jonction du thermocouple sur le côté opposé de l'ensemble, dit côté froid, au moins un premier et un deuxième plots de connexion agencés pour transférer de la chaleur respectivement à chaque première jonction et à chaque deuxième jonction, le capteur étant remarquable en ce qu'il comporte :

- un organe de support thermiquement isolant agencé pour supporter le substrat, l'organe de support comprenant au moins une première et deuxième broches de connexion métalliques,
- des premiers et des deuxièmes moyens de connexion métalliques agencés pour connecter électriquement l'organe de support avec respectivement le ou chaque premier plot de connexion et le ou chaque deuxième plot de connexion,
- un boîtier externe renfermant l'ensemble de couches thermoélectriques et l'organe de support, le boîtier externe comprenant une première face et une deuxième face opposée destinées à être respectivement connectées à la source chaude et à la source froide, un premier via reliant la première face à chaque première broche de connexion, un deuxième via reliant la deuxième face à chaque deuxième broche de connexion, et en ce que l'organe de support comporte des moyens de transfert thermique agencés pour transférer la chaleur de chaque première broche de connexion vers les premiers moyens de connexion métalliques, et pour transférer la chaleur des deuxièmes moyens de connexion métalliques vers chaque deuxième broche de connexion.

Ainsi, un tel capteur selon l'invention est intégré directement à l'organe de support grâce aux premiers et aux deuxièmes moyens de connexion métalliques.

Les broches de connexion métalliques de l'organe de support permettent d'assurer à la fois :

- une connexion électrique de l'organe de support avec par exemple une carte électronique,
- une bonne conduction thermique entre les sources chaude et froide et l'organe de support par l'intermédiaire des premier et deuxième vias.

La nature métallique des premiers et deuxièmes moyens de connexion permet d'assurer à la fois :

- une connexion électrique de l'organe de support avec les plots de connexion,
- une bonne conduction thermique entre l'organe de support et les plots de connexion.

Par « thermiquement isolant », on entend que l'organe de support présente une conductivité thermique supérieure à une valeur de l'ordre de 150 W/m/K.

Par « thermiquement conducteur », on entend une entité présentant une conductivité thermique inférieure à une valeur de l'ordre de 150 W/m/K.

L'organe de support est thermiquement isolant de manière à éviter la formation d'un pont thermique entre les premiers et les deuxièmes moyens de connexion métalliques via l'organe de support. Ainsi, le gradient thermique entre la source chaude et la source froide peut être répercuté entre les premiers et les deuxièmes moyens de connexion métalliques, et par là-même entre le côté chaud et le côté froid de l'ensemble de couches thermoélectriques via le premier et le deuxième plots de connexion.

En outre, les pertes thermiques liées à l'intégration sont fortement réduites grâce aux moyens de transfert thermique et aux premiers et aux deuxièmes moyens de connexion métalliques.

Par ailleurs, le boîtier externe autorise la mesure de température lorsque les sources chaude et froide sont agencées de part et d'autre de l'organe de support dans un plan orthogonal au substrat, et ce tout en conservant une puce-capteur intégrée. Par « puce-capteur », on entend la structure formée par le substrat, l'ensemble de couches thermoélectriques et les plots de connexion. L'épaisseur du boîtier externe et les première et deuxième faces du boîtier externe sont adaptées à la distance séparant les sources chaude et froide. Les faces et les vias du boîtier externe transfèrent la chaleur entre les sources chaude et froide et l'organe de support.

Avantageusement, les première et deuxième faces du boîtier externe sont revêtues d'un matériau thermiquement conducteur.

Ainsi, le transfert de la chaleur entre les sources chaude et froide et les vias est amélioré. Les faces rendues thermiquement conductrices et les vias transfèrent la chaleur entre les sources chaude et froide et l'organe de support.

Selon un mode de réalisation, le capteur comporte une couche d'encapsulation agencée sur l'organe de support de manière à encapsuler l'ensemble de couches thermoélectriques, la couche d'encapsulation étant de préférence réalisée dans un matériau à base d'un polymère.

Selon un mode de réalisation, le capteur comporte un boîtier de circuit intégré renfermant l'ensemble de couches thermoélectriques, le boîtier de circuit intégré comportant l'organe de support, et le boîtier externe renferme le boîtier de circuit intégré.

Ainsi, un tel capteur selon l'invention est intégré directement au boîtier de circuit intégré grâce aux premiers et aux deuxièmes moyens de connexion métalliques. L'épaisseur du boîtier externe et les première et deuxième faces du boîtier externe sont adaptées à la distance séparant les sources chaude et froide, les dimensions du boîtier de circuit intégré pouvant alors être fixes. En outre, le boîtier de circuit intégré permet d'encapsuler l'ensemble de couches thermoélectriques.

Avantageusement, le boîtier de circuit intégré comporte au moins une broche de connexion électrique, et le boîtier externe comporte au moins une piste électrique s'étendant à partir de la broche de connexion électrique.

Ainsi, une telle piste électrique permet de définir une sortie électrique pour le boîtier externe.

Avantageusement, le boîtier externe comporte un organe de support agencé pour supporter le boîtier de circuit intégré.

Ainsi, l'organe de support du boîtier externe permet d'améliorer la tenue mécanique du capteur.

Selon un mode de réalisation, les premiers et les deuxièmes moyens de connexion métalliques comportent une bille de brasage brasée respectivement sur le ou chaque premier plot de connexion et sur le ou chaque deuxième plot de connexion de manière à assembler le substrat et l'organe de support.

Ainsi, de telles billes de brasage métalliques possèdent d'excellentes propriétés de conduction thermique.

Selon une variante d'exécution, les premiers et les deuxièmes moyens de connexion métalliques comportent un fil de câblage soudé respectivement sur le ou chaque premier plot de connexion et sur le ou chaque deuxième plot de connexion de manière à assembler le substrat et l'organe de support.

Selon un mode de réalisation, les moyens de transfert thermique comportent :

- au moins une première piste métallique reliant les premiers moyens de connexion à la ou chaque première broche de connexion métallique,
- au moins une deuxième piste métallique reliant les deuxièmes moyens de connexion à la ou chaque deuxième broche de connexion métallique.

Ainsi, de telles pistes métalliques peuvent être dessinées au sein de l'organe de support de manière à :

- éviter un pont thermique entre le côté chaud et le côté froid de l'ensemble,
- assurer une connexion électrique,
- assurer une bonne conduction thermique entre les broches de connexion métalliques et les moyens de connexion correspondants.
- maintenir une bonne tenue mécanique des pistes.

Avantageusement, l'ensemble de couches thermoélectriques présente une surface libre, et le capteur comporte un premier et un deuxième éléments thermiquement conducteurs s'étendant en regard et à distance de ladite surface libre, et dans le prolongement respectivement du côté chaud et du côté froid dudit ensemble.

Ainsi, de tels éléments thermiquement conducteurs permettent d'homogénéiser le transfert de chaleur entre le côté chaud et le côté froid de l'ensemble de couches thermoélectriques.

Avantageusement, le capteur comporte une couche diélectrique interposée entre le substrat et l'ensemble de couches thermoélectriques.

Ainsi, une telle couche diélectrique permet d'isoler électriquement et thermiquement le substrat.

Selon une forme d'exécution, le substrat est réalisé dans un matériau à base de silicium.

Selon une variante d'exécution, le substrat est réalisé dans un matériau thermiquement isolant, tel que le verre ou le quartz.

La présente invention concerne également un dispositif de mesure différentielle de température, comportant :

- une pluralité de capteurs conformes à l'invention,
- un premier circuit imprimé, l'organe de support de chaque capteur étant formé sur le premier circuit imprimé,
- un deuxième circuit imprimé agencé en regard du premier circuit imprimé de sorte que les premier et deuxième circuits imprimés forment le boîtier externe renfermant l'ensemble de couches thermoélectriques et l'organe de support de chaque capteur.

Ainsi, un tel dispositif selon l'invention permet de mesurer simultanément la température de différents milieux.

**Brève description des dessins**

D'autres caractéristiques et avantages apparaîtront dans la description qui va suivre de différents modes de réalisation d'un capteur et d'un dispositif selon l'invention, donnés à titre d'exemples non limitatifs, en référence aux dessins annexés dans lesquels :

- la figure 1 est une vue schématique de dessus d'un capteur de l'état de la technique (déjà commentée),
- la figure 2 est une vue schématique partielle de côté d'un capteur selon un mode de réalisation de l'invention,
- la figure 3 est une vue schématique partielle de dessus d'un capteur selon un mode de réalisation de l'invention,
- la figure 4 est une vue schématique partielle de côté du mode de réalisation illustré à la figure 3,
- la figure 5 est une vue schématique en perspective d'un boîtier de circuit intégré pouvant intégrer un capteur selon l'invention,
- la figure 6 est une vue schématique en perspective du boîtier retourné illustré à la figure 5,
- la figure 7 est une vue schématique de côté d'un capteur selon un mode de réalisation de l'invention,
- la figure 8 est une vue schématique de côté d'un capteur selon un mode de réalisation de l'invention,
- la figure 9 est une vue schématique de côté d'un capteur selon un mode de réalisation de l'invention,
- la figure 10 est une vue schématique de côté d'un capteur selon un mode de réalisation de l'invention,
- les figures 11a à 11c sont des vues schématiques de dessus illustrant différentes formes d'exécution de vias,
- les figures 12a à 12c sont des vues schématiques en coupe des formes d'exécution illustrées aux figures 11a à 11c,
- les figures 13a à 13c sont des vues schématiques de dessus de différentes formes d'exécution de vias,

- les figures 14a à 14c sont des vues schématiques en coupe des formes d'exécution illustrées aux figures 13a à 13c,
- les figures 15a à 15c sont des vues schématiques en coupe des formes d'exécution illustrées aux figures 13a à 13c,
- les figures 16a à 16c sont des vues schématiques de dessus illustrant différentes positions de sorties électriques du boîtier externe,
- les figures 17a à 17c sont des vues schématiques en coupe pour les positions illustrées aux figures 16a à 16c,
- les figures 18a à 18c sont des vues schématiques en coupe pour les positions illustrées aux figures 16a à 16c,
- les figures 19a à 19c sont des vues de dessus et en coupe d'un capteur selon un mode de réalisation de l'invention,
- les figures 20a à 20c sont des vues de dessus et en coupe d'un capteur selon un mode de réalisation de l'invention,
- les figures 21 a à 21c sont des vues de dessus et en coupe d'un capteur selon un mode de réalisation de l'invention,
- les figures 22a à 22c sont des vues de dessus et en coupe d'un capteur selon un mode de réalisation de l'invention,
- les figures 23a à 23c sont des vues de dessus et en coupe d'un capteur selon un mode de réalisation de l'invention,
- la figure 24 est une vue en coupe d'un dispositif selon l'invention,
- la figure 25 est une vue partielle de dessus du dispositif illustré à la figure 24,
- la figure 26 est une vue partielle de dessus du dispositif illustré à la figure 24.

Pour les différents modes de réalisation, les mêmes références seront utilisées pour des éléments identiques ou assurant la même fonction, par souci de simplification de la description. Les caractéristiques techniques décrites ci-après pour différents modes de réalisation sont à considérer isolément ou selon toute combinaison techniquement possible.

**Exposé détaillé des modes de réalisation**

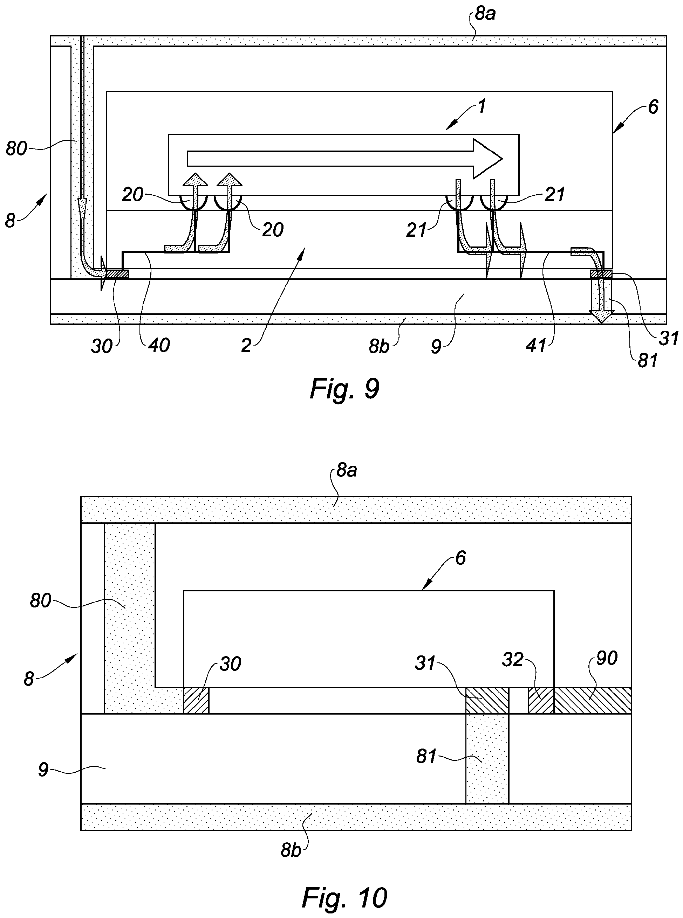

Aux figures 2 à 23c est illustré un capteur 1 différentiel de température entre une source chaude Sc et une source froide Sf, le capteur 1 comportant :

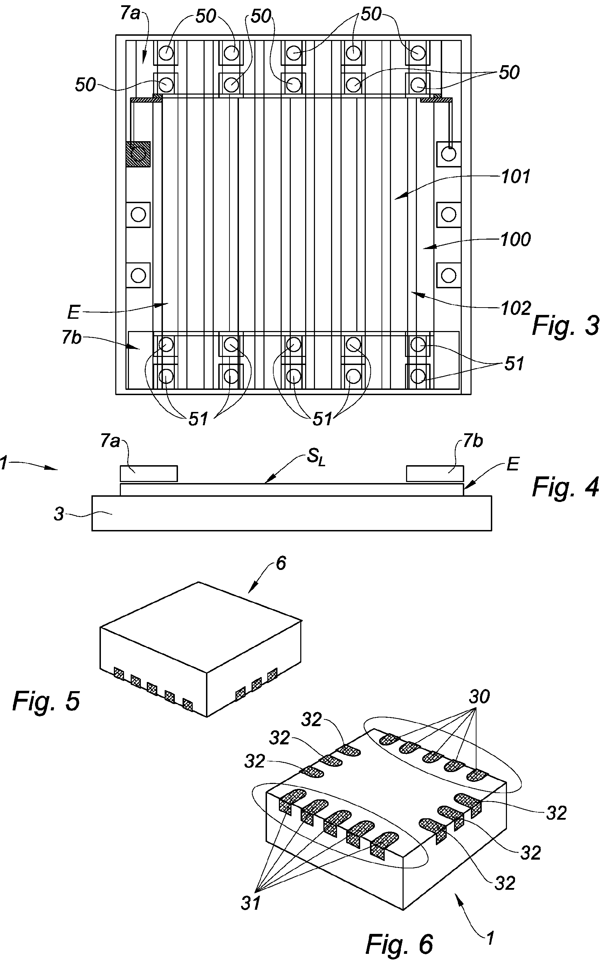

- un substrat 3 (visible à la figure 4),
- un ensemble E de couches thermoélectriques agencé sur le substrat 3 (l'ensemble E et le substrat 3 étant représentés schématiquement par un rectangle aux figures 2 et 7 à 9), l'ensemble E comprenant au moins une première jonction 10 d'un thermocouple 100, 101 sur un côté de l'ensemble E, dit côté chaud, et au moins une deuxième jonction 11 du thermocouple 100, 101 sur le côté opposé de l'ensemble E, dit côté froid,

- au moins un premier et un deuxième plots de connexion 50, 51 agencés pour transférer de la chaleur respectivement à chaque première jonction 10 et à chaque deuxième jonction 11.

Le capteur 1 comporte en outre :

- un organe de support 2 thermiquement isolant agencé pour supporter le substrat 3, l'organe de support 2 comprenant au moins une première et une deuxième broches de connexion 30, 31 métalliques,
- des premiers et des deuxièmes moyens de connexion métalliques agencés pour connecter électriquement l'organe de support 2 avec respectivement le ou chaque premier plot de connexion 50 et le ou chaque deuxième plot de connexion 51,
- un boîtier externe 8 renfermant l'ensemble E de couches thermoélectriques et l'organe de support 2, le boîtier externe 8 comprenant :

  une première face 8a et une deuxième face 8b opposée destinées à être respectivement connectées à la source chaude Sc et à la source froide Sf,
  un premier via 80, de préférence métallique, reliant la première face à chaque première broche de connexion 30,
  un deuxième via 81, de préférence métallique, reliant la deuxième face à chaque deuxième broche de connexion 31.

L'organe de support 2 comporte des moyens de transfert thermique agencés pour transférer la chaleur de chaque première broche de connexion 30 vers les premiers moyens de connexion métalliques, et pour transférer la chaleur des deuxièmes moyens de connexion métalliques vers chaque deuxième broche de connexion 31.

Les termes « chaud(e) » et « froid(e) » s'entendent de manière relative, c'est-à-dire que la température de la source « chaude » est supérieure à la température de la source « froide ».

Par la suite, la structure formée par le substrat 3, l'ensemble E de couches thermoélectriques et les plots de connexion 50, 51 sera appelée « puce-capteur ».

Par « puce », on entend une plaquette formant substrat, de préférence dans un matériau à base de silicium, comportant un composant élémentaire.

Le substrat 3 est avantageusement plan. Le substrat 3 présente avantageusement une épaisseur comprise entre 100 et 200 $\mu$m afin de limiter le transfert de chaleur vers le substrat 3. En outre, on appelle « première direction » la direction s'étendant suivant l'épaisseur du substrat 3.

L'ensemble E de couches thermoélectriques comporte N thermocouples 100, 101, c'est-à-dire N couches réalisées à base d'un premier matériau thermoélectrique 100 et N couches réalisées à base d'un second matériau thermoélectrique 101. Le premier matériau thermoélectrique 100 est avantageusement dopé électriquement selon un premier type de conductivité. Le second matériau thermoélectrique 101 est avantageusement dopé selon un second type de conductivité. Chaque première jonction 10 et chaque deuxième jonction 11 sont formées avec un matériau électriquement conducteur. Les couches thermoélectriques sont séparées par un matériau thermiquement isolant 102. Les N thermocouples 100, 101 et le matériau thermiquement isolant 102 sont juxtaposés suivant une direction perpendiculaire à la première direction.

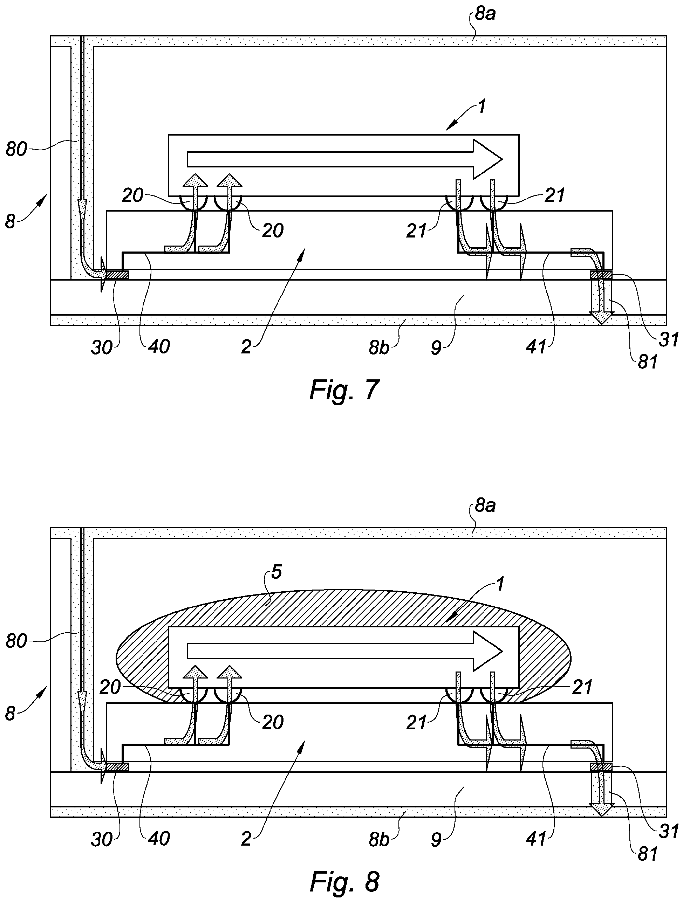

Dans le mode de réalisation illustré à la figure 8, le capteur 1 comporte une couche d'encapsulation 5 agencée sur l'organe de support 2 de manière à encapsuler l'ensemble E de couches thermoélectriques. La couche d'encapsulation 5 est de préférence réalisée dans un matériau à base d'un polymère.

Selon une variante de réalisation, le capteur 1 comporte un boîtier 6 de circuit intégré renfermant l'ensemble E de couches thermoélectriques, le boîtier 6 de circuit intégré comportant l'organe de support 2. Le boîtier externe 8 renferme le boîtier 6 de circuit intégré.

A titre d'exemple non limitatif, le boîtier 6 de circuit intégré peut être de type SMD (*Surface Mounted Device)*. Le boîtier 6 est de préférence réalisé dans un matériau thermiquement isolant. Le boîtier 6 présente de préférence une épaisseur comprise entre 0,1 et quelques mm. Le boîtier 6 ne présente pas de préférence de surface métallique centrale utilisée classiquement comme dissipateur de chaleur afin de ne pas nuire au transfert thermique entre le boîtier 6 et la puce-capteur.

Comme illustré à la figure 6, le boîtier 6 comporte avantageusement :

- une rangée de premières broches de connexion 30 métalliques reliées à des premières pistes métalliques 40, les premières pistes métalliques 40 formant moyens de transfert thermique agencés pour transférer la chaleur de chaque première broche de connexion 30 vers les premiers moyens de connexion métalliques,
- une rangée de deuxièmes broches de connexion 31 métalliques reliées à des deuxièmes pistes métalliques 41, les deuxièmes pistes métalliques 41 formant moyens de transfert thermique agencés pour transférer la chaleur des deuxièmes moyens de connexion métalliques vers chaque deuxième broche de connexion 31.

Les rangées de broches de connexion 30, 31 peuvent être continues de manière à former des barrettes. Le boîtier 6 comporte des rangées de broches de connexion 32 métalliques additionnelles qui ne sont pas utilisées comme moyens de transfert thermique. Les broches de connexion 32 métalliques additionnelles sont utilisées comme de simples connecteurs électriques. La puce-capteur peut comporter des plots de connexion électrique connectés électriquement à chaque première jonction 10 et à chaque deuxième jonction 11. Les broches de connexion 32 peuvent être connectées électriquement auxdits plots de connexion électrique. L'homme du métier peut choisir différents agencements pour les broches de connexion 30, 31 utilisées comme moyens de transfert thermique, et pour les broches de connexion 32 utilisées comme connecteurs électriques. Ces différents agencements seront choisis notamment en fonction de l'application envisagée, du positionnement des sources chaude et froide Sc, Sf, et des connectiques pour l'intégration de la puce-capteur. Il est également possible d'utiliser au moins une broche de connexion métallique à la fois comme connecteur électrique et comme moyen de transfert thermique.

Dans un mode de réalisation, les premiers moyens de connexion métalliques comportent une bille de brasage 20 brasée sur chaque premier plot de connexion 50. Les deuxièmes moyens de connexion métalliques comportent une bille de brasage 21 brasée sur chaque deuxième plot de connexion 51. Les billes de brasage 20, 21 permettent en outre d'assembler le substrat 3 et l'organe de support 2. A cet effet, le capteur 1 peut comporter des billes de brasage additionnelles 22 (visibles à la figure 2) qui ne sont pas connectées électriquement aux plots de connexion 50, 51 mais contribuent à assembler le substrat 3 avec l'organe de support 2 pour améliorer la tenue mécanique. Les billes de brasage 20, 21, 22 sont de préférence réalisées à base d'un matériau sélectionné dans le groupe comportant Au, SnAgAu, SnAgCu. Les billes de brasage 20, 21, 22 présentent avantageusement un diamètre de l'ordre de 80 μm pour une épaisseur de l'ordre de 80 μm. De telles dimensions permettent d'associer compacité et surface de transfert thermique suffisante pour la fonctionnalité du capteur 1. Bien entendu, le diamètre et l'épaisseur des billes de brasage 20, 21, 22 peuvent varier, par exemple entre quelques dizaines et quelques centaines de microns. Le substrat 3 et l'organe de support 2 appartenant au boîtier 6 sont avantageusement assemblés par le procédé de la puce retournée (*Flip-Chip* en langue anglaise), connu de l'homme du métier, lorsque les moyens de connexion métalliques comportent des billes de brasage 20, 21, 22. Le substrat 3 et l'organe de support 2 appartenant au boîtier 6 sont avantageusement assemblés par le procédé de câblage par fil (*Wire bonding* en langue anglaise), connu de l'homme du métier, lorsque les moyens de connexion métalliques comportent des fils de câblage soudés.

Les premières pistes métalliques 40 relient les billes de brasage 20 aux premières broches de connexion 30. Les deuxièmes pistes métalliques 41 relient les billes de brasage 21 aux deuxièmes broches de connexion 31.

Les flèches de la figure 7 indiquent le sens du transfert de la chaleur au sein du capteur 1. Les pistes métalliques 40, 41 peuvent être ménagées à travers l'organe de support 2. De telles pistes métalliques 40, 41 sont dessinées au sein de l'organe de support 2 de manière à :

- éviter un pont thermique entre le côté chaud et le côté froid de l'ensemble E,
- assurer une connexion électrique,
- assurer une bonne connexion thermique entre les broches de connexion 30, 31 et les billes de brasage 20, 21.
- maintenir une bonne tenue mécanique des pistes.

Pour ce faire, à titre d'exemple non limitatif, de telles pistes métalliques 40, 41 présentent une épaisseur de l'ordre de quelques dizaines de nm pour une épaisseur de l'organe de support 2 de l'ordre de 100 nm.

La première face 8a et la deuxième face 8b opposée du boîtier externe 8 sont avantageusement revêtues d'un matériau thermiquement conducteur, et sont destinées à être respectivement connectées à la source chaude Sc et à la source froide Sf. La connexion peut être directe, c'est-à-dire que les première et deuxième faces 8a, 8b sont respectivement en contact direct avec la source chaude Sc et la source froide Sf. La connexion peut-être indirecte, c'est-à-dire que les faces 8a, 8b sont connectées thermiquement auxdites sources Sc, Sf via un chemin thermique. Le boîtier externe 8 est réalisé avantageusement dans un matériau thermiquement isolant. Les faces 8a, 8b sont rendues thermiquement conductrices de préférence au moyen d'un revêtement à base d'un matériau thermiquement conducteur. Le matériau thermiquement conducteur du revêtement peut être un métal tel que Cu, Au, Ag, ou un alliage à base d'argent, ou un matériau sélectionné dans le groupe comportant SiC, AlN, Al anodisé. Le matériau thermiquement conducteur du revêtement peut être déposé sur le boîtier externe 8 selon différentes techniques telles que le dépôt chimique en phase vapeur (CVD) ou le dépôt physique en phase vapeur (PVD). Le matériau thermiquement conducteur du revêtement peut être soudé ou brasé directement sur le boîtier externe 8. Le boîtier externe 8 comporte avantageusement un organe de support 9 agencé pour supporter le boîtier 6 de circuit intégré à l'intérieur du boîtier externe 8. Le boîtier 6 de circuit intégré est avantageusement fixé à l'organe de support 9 du boîtier externe 8 par collage, brasure ou soudure. L'organe de support 9 du boîtier externe 8 comporte des orifices ménagés en son sein pour recevoir les deuxièmes via 81. Le boîtier externe 8 est réalisé avantageusement dans un matériau thermiquement isolant de manière à éviter la formation d'un pont thermique entre le premier via 80 et le deuxième via 81 par l'intermédiaire de l'organe de support 9 du boîtier externe 8. Ainsi, le gradient thermique entre la source chaude Sc et la source froide Sf peut être répercuté entre chaque première broche de connexion 30 et chaque deuxième broche de connexion 31, et par là-même entre le côté chaud et le côté froid de l'ensemble E de couches thermoélectriques. L'enceinte délimitée par le boîtier externe 8 peut être avantageusement mise sous vide afin de concentrer le transfert de chaleur sur les vias 80, 81.

Le premier via 80 pouvant être à proximité de la source froide Sf, il est nécessaire de configurer correctement géométriquement le premier via 80 ainsi que l'organe de support 9 du boîtier externe 8. Pour ce faire, l'équation ci-après doit être vérifiée :

$$\phi = \frac{e_{supp} \times \lambda_{via} \times S_{via}}{\lambda_{supp} \times S_{supp} \times e_{via}} \gg 1$$

où :

- $e_{supp}$ est l'épaisseur de l'organe de support 9 du boîtier externe 8,
- $e_{via}$ est l'épaisseur du premier via 80,
- $\lambda_{supp}$ est la conductivité thermique de l'organe de support 9 du boîtier externe 8,
- $\lambda_{via}$ est la conductivité thermique du premier via 80,
- $S_{supp}$ est la surface latérale de conduction thermique de l'organe de support 9 du boîtier externe 8,
- $S_{via}$ est la surface latérale de conduction thermique du premier via 80.

Par « latérale », on entend une direction parallèle à la première direction, c'est-à-dire la direction s'étendant suivant l'épaisseur du substrat 3.

A titre d'exemple non limitatif, le tableau ci-après rassemble des paramètres permettant de configurer correctement géométriquement le premier via 80 ainsi que l'organe de support 9 du boîtier externe 8 :

| Paramètre | |
|---|---|
| $e_{supp}$ | 200 $\mu$m |
| $e_{via}$ | 700 $\mu$m |
| $\lambda_{supp}$ | 0,2 W/m/K (résine epoxy) |
| $\lambda_{via}$ | 386 W/m/K (Cu) |
| $S_{supp}$ | 5x5 mm$^2$ |
| $S_{via}$ | 3x1 mm$^2$ |
| Φ | 66 |

Les vias 80, 81 sont avantageusement réalisés dans un matériau thermiquement conducteur. Les vias 80, 81 sont de préférence métalliques. Les vias 80,81 sont avantageusement réalisés dans un matériau à base de cuivre ou d'or.

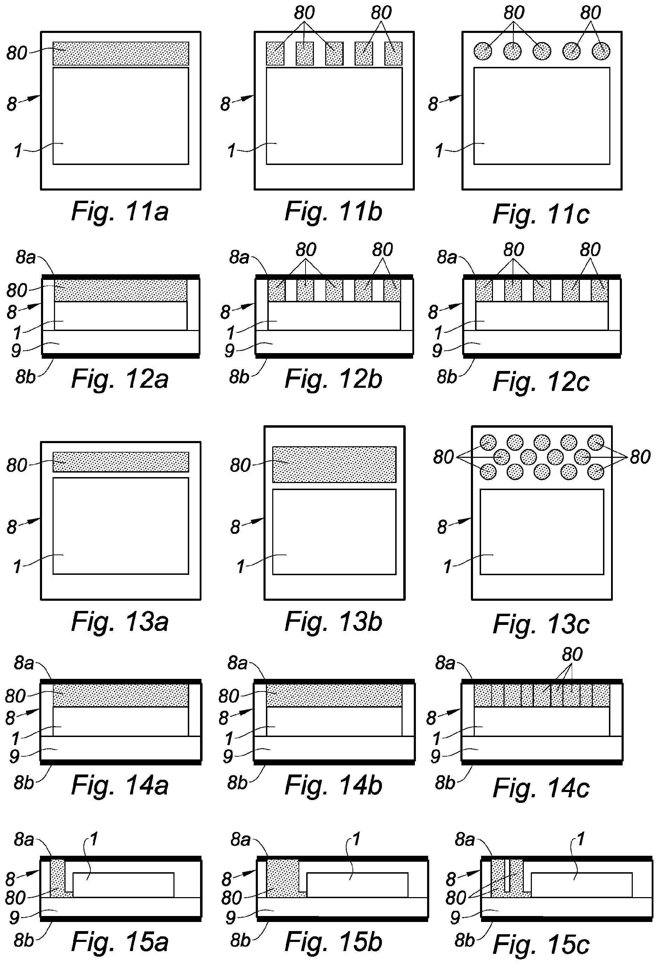

Les vias 80, 81 peuvent avoir différentes formes. Comme illustré aux figures 11 a à 11c et 13a à 13c, les vias 80, 81 peuvent présenter une section dans le plan du substrat 3 de forme rectangulaire, carrée ou circulaire.

Les vias 80, 81 peuvent être monobloc (illustré notamment aux figures 11a et 13b) ou formés en plusieurs puits (illustré notamment aux figures 11b, 11c et 13c).

Il est à noter que seuls les premiers vias 80 sont représentés aux figures 11 a à 15c pour des raisons de simplicité. Bien entendu, les caractéristiques décrites s'appliquent également aux deuxièmes vias 81.

Selon une forme d'exécution, les vias 80, 81 sont pleins, c'est-à-dire remplis d'un matériau thermiquement conducteur tel qu'un métal. Selon une variante d'exécution, les vias 80, 81 sont creux, c'est-à-dire évidés en leur centre de manière à former une paroi cylindrique thermiquement conductrice, la paroi cylindrique étant de préférence métallique.

Les vias 80, 81 peuvent être reliés directement aux broches de connexion 30, 31 ou indirectement par l'intermédiaire de pistes métalliques. Ces différentes architectures de vias 80, 81 permettent de modifier les paramètres $e_{via}$ et $S_{via}$ de sorte que $\Phi \gg 1$.

Le boîtier 6 de circuit intégré comporte avantageusement au moins une broche de connexion électrique 32 qui n'est pas utilisée comme moyens de transfert thermique. Le boîtier externe 8 comporte avantageusement au moins une piste électrique 90 s'étendant à partir de la broche de connexion 32 électrique. L'homme du métier peut choisir différents agencements pour les broches de connexion 32 électrique notamment en fonction de l'application envisagée, du positionnement des sources chaude et froide Sc, Sf. Ainsi, l'homme du métier peut choisir différents agencements pour les pistes électriques 90 en fonction des agencements desdites broches de connexion 32 électriques afin de définir différentes positions de sorties électriques S pour le boîtier externe 8. La ou chaque piste électrique 90 est avantageusement ménagée dans l'organe de support 9 du boîtier externe 8.

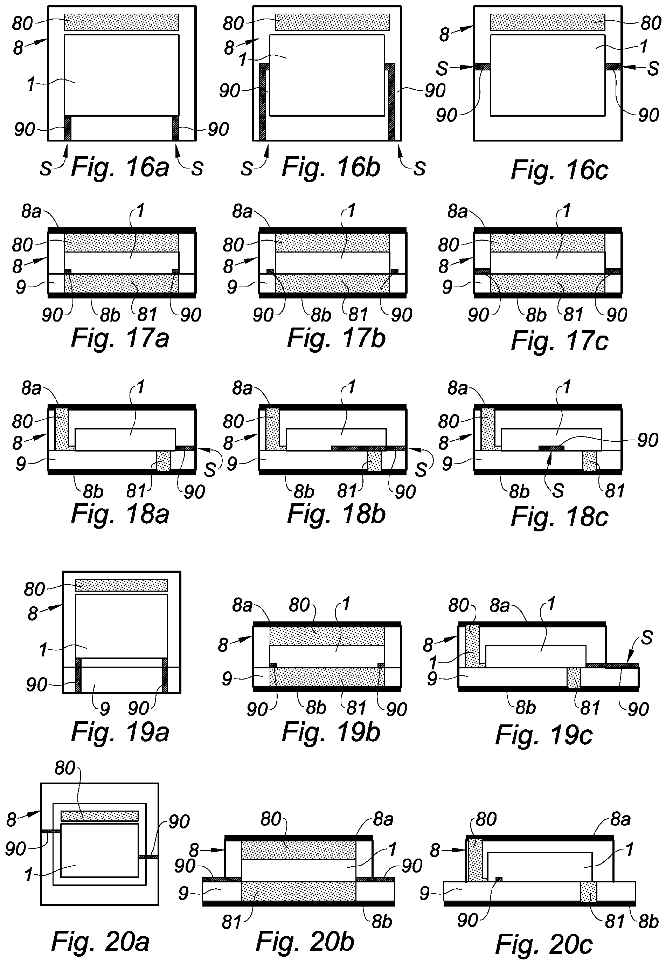

A titre d'exemples non limitatifs, les figures 16a à 16c illustrent deux sorties électriques S disposées sur des portions périphériques d'un bord du boîtier externe 8, ou disposées sensiblement au milieu de deux bords opposés du boîtier externe 8. Le nombre de sorties électriques S n'est pas limité au nombre de 2 ; il peut être compris entre 1 et N, N étant un nombre entier naturel. Les sorties électriques S sont avantageusement réparties aléatoirement sur les bords du boîtier externe 8 en fonction des agencements des broches de connexion 32 électriques.

Comme illustré aux figures 19a à 19c et 20a à 20c, la première face 8a du boîtier externe présente avantageusement un décrochement relativement à l'organe de support 9 du boîtier externe 8 de manière à améliorer l'accessibilité des sorties électriques S lorsque les pistes électriques 90 sont ménagées dans l'organe de support 9 du boîtier externe 8.

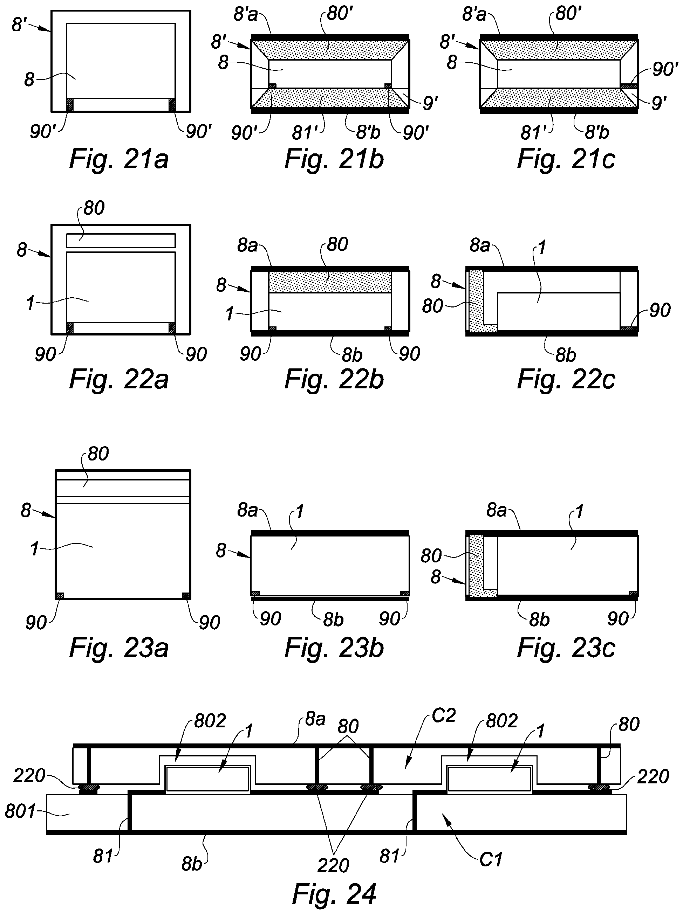

Dans un mode de réalisation illustré aux figures 21a à 21c, le capteur 1 comporte avantageusement un boîtier externe additionnel 8' renfermant le boîtier externe 8.

Le boîtier externe additionnel 8' comporte :

- une première face 8'a et une deuxième face 8'b opposée destinées à être respectivement connectées à la source chaude Sc et à la source froide Sf,
- un premier via 80' reliant ladite première face 8'a à la première face 8a du boîtier externe 8, le premier via 80' s'étendant directement sur la première face 8a du boîtier externe 8,
- un deuxième via 81' reliant ladite deuxième face 8'b à la deuxième face 8b du boîtier externe 8, le deuxième via 81' s'étendant directement sur la deuxième face 8b du boîtier externe 8,
- un organe de support 9' agencé pour supporter le boîtier externe 8.

Ainsi, un tel boîtier externe additionnel 8' permet une adaptation du capteur 1 à la distance séparant les sources chaude et froide, et ce tout en conservant un boîtier externe 8 déjà configuré. Cette adaptation est effectuée en modifiant notamment l'épaisseur des vias 80', 81'.

Dans un mode de réalisation illustré aux figures 22a à 22c, le boîtier externe 8 ne comporte pas d'organe de support 9.

Dans un mode de réalisation illustré aux figures 23a à 23c, la première face 8a et la deuxième face 8b opposée du boîtier externe 8 s'étendent directement sur le boîtier 6 de circuit intégré de manière à obtenir un capteur 1 le plus compact possible.

Dans un mode de réalisation illustré aux figures 2 et 3, l'ensemble E de couches thermoélectriques présente une surface libre $S_L$, le capteur comporte un premier et un deuxième éléments thermiquement conducteurs 7a, 7b s'étendant en regard et à distance de ladite surface libre $S_L$, et dans le prolongement respectivement du côté chaud et du côté froid dudit ensemble E. Autrement dit, les premier et deuxième éléments thermiquement conducteurs 7a, 7b surmontent des zones latérales de la surface libre $S_L$ sans contact direct. Les premier et deuxième éléments thermiquement conducteurs 7a, 7b peuvent être réalisés dans tout matériau thermiquement conducteur, comme décrit dans le document WO 2011012586. Les premier et deuxième éléments thermiquement conducteurs 7a, 7b sont avantageusement métalliques. Les premier et deuxième éléments thermiquement conducteurs 7a, 7b sont avantageusement réalisés sous la forme d'une bande métallique.

Dans un mode de réalisation, le capteur 1 comporte une couche diélectrique interposée entre le substrat 3 et l'ensemble E de couches thermoélectriques. Lorsque le substrat 3 est réalisé dans un matériau à base de silicium, la couche diélectrique est avantageusement du $SiO_2$ ou du $Si_3N_4$. La couche diélectrique présente une épaisseur comprise entre quelques nm et plusieurs centaines de $\mu m$.

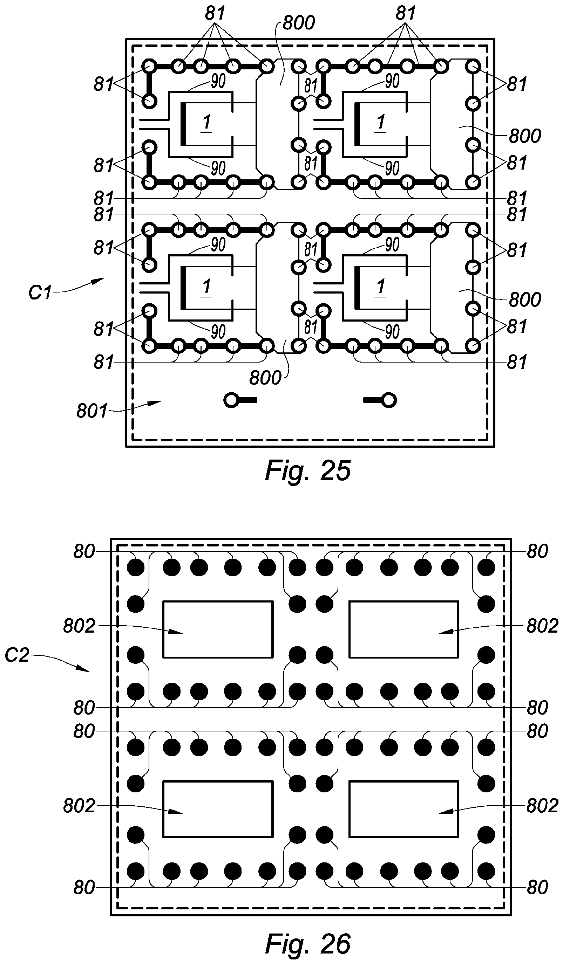

Aux figures 24 à 26 est illustré un dispositif de mesure différentielle de température, comportant :

- une pluralité de capteurs 1,
- un premier circuit C1 imprimé, l'organe de support 2 (non représenté) de chaque capteur 1 étant formé sur le premier circuit imprimé C1,
- un deuxième circuit C2 imprimé agencé en regard du premier circuit C1 imprimé de sorte que les premier et deuxième circuits C1, C2 imprimés forment le boîtier externe 8 renfermant l'ensemble E de couches thermoélectriques (non représenté) et l'organe de support 2 de chaque capteur 1.

Le premier circuit C1 comporte une face externe formant la deuxième face 8b du boîtier externe 8. Le deuxième circuit C2 comporte une face externe formant la première face 8a du boîtier externe 8, la première face 8a et la deuxième face 8b étant opposées. Le premier circuit C1 comporte au moins un via 81 reliant la deuxième face 8b à chaque broche de connexion 31 de l'organe de support 2 de chaque capteur 1. Le deuxième circuit C2 comporte au moins un via 80 reliant la première face 8a à chaque première broche de connexion 30 de l'organe de support 2 de chaque capteur 1.

L'organe de support 2 de chaque capteur 1 est avantageusement formé sur le premier circuit C1 par brasage, de la même façon qu'un composant monté en surface (SMD pour l'expression anglaise *Surface Mounted Device*).

Chaque circuit C1, C2 est réalisé de préférence dans un matériau 801 de type FR-4 (acronyme pour l'expression anglaise *Flame Resistant* 4), comportant un composite de fibres de verre et de résine époxy, les pistes 800 de chaque circuit C1, C2 étant de préférence réalisées en cuivre.

Le premier circuit C1 est avantageusement plan. Le premier circuit C1 présente avantageusement une épaisseur comprise entre 100 $\mu$m et 5 mm, de préférence comprise entre 1 mm et 2 mm. La face externe du premier circuit C1 formant la deuxième face 8b du boîtier externe 8 est avantageusement réalisée à partir d'un plan métallique, de préférence en cuivre. Le cuivre est avantageusement traité en surface par un étamage ou par un dépôt de Nickel-or.

Le deuxième circuit C2 comporte une pluralité de cavités 802 ménagées en son sein, chaque cavité 802 étant conformée pour recevoir un capteur 1. La pluralité de cavités 802 est de préférence obtenue par fraisage. Le deuxième circuit C2 présente avantageusement une épaisseur supérieure à l'épaisseur d'un capteur 1 de 500 $\mu$m. Le deuxième circuit C2 présente préférentiellement une épaisseur de l'ordre de 1,6 mm.

Le deuxième circuit C2 est avantageusement monté sur le premier circuit C1 par l'intermédiaire d'une pâte à braser 220. La pâte à braser 220 est réalisée de préférence à base d'un matériau sélectionné dans le groupe comportant Au, SnAgAu, SnAgCu. La pâte à braser 220 est avantageusement déposée par sérigraphie sur le premier circuit C1. Les circuits C1 et C2 sont avantageusement solidarisés par un recuit dans un four de brasage. Puis il est possible d'appliquer un polymère dit de remplissage (*underfill* en langue anglaise) par infiltration afin de combler les éventuels jours entre les circuits C1 et C2 et renforcer la tenue mécanique du dispositif.

## Revendications

1. Capteur (1) différentiel de température entre une source chaude (Sc) et une source froide (Sf), le capteur (1) comportant un substrat (3), un ensemble (E) de couches thermoélectriques agencé sur le substrat (3), l'ensemble (E) comprenant au moins une première jonction (10) d'un thermocouple (100, 101) sur un côté de l'ensemble (E), dit côté chaud, et au moins une deuxième jonction (11) du thermocouple (100, 101) sur le côté opposé de l'ensemble (E), dit côté froid, au moins un premier et un deuxième plots de connexion (50, 51) agencés pour transférer de la chaleur respectivement à chaque première jonction (10) et à chaque deuxième jonction (11), le capteur étant **caractérisé en ce qu'**il comporte :

   - un organe de support (2) thermiquement isolant agencé pour supporter le substrat (3), l'organe de support (2) comprenant au moins une première et une deuxième broches de connexion (30, 31) métalliques,
   - des premiers et des deuxièmes moyens de connexion métalliques agencés pour connecter électriquement l'organe de support (2) avec respectivement le ou chaque premier plot de connexion (50) et le ou chaque deuxième plot de connexion (51),
   - un boîtier externe (8) renfermant l'ensemble (E) de couches thermoélectriques et l'organe de support (2), le boîtier externe (8) comprenant une première face (8a) et une deuxième face (8b) opposée destinées à être respectivement connectées à la source chaude (Sc) et à la source froide (Sf), un premier via (80) reliant la première face (8a) à chaque première broche de connexion (30), un deuxième via (81) reliant la deuxième face (8b) à chaque deuxième broche de connexion (31), et **en ce que** l'organe de support (2) comporte des moyens de transfert thermique agencés pour transférer la chaleur de chaque première broche de connexion (30) vers les premiers moyens de connexion métalliques, et pour transférer la chaleur des deuxièmes moyens de connexion métalliques vers chaque deuxième broche de connexion (31).

2. Capteur (1) selon la revendication 1, **caractérisé en ce que** les première et deuxième faces (8a, 8b) du boîtier externe (8) sont revêtues d'un matériau thermiquement conducteur.

3. Capteur (1) selon la revendication 1 ou 2, **caractérisé en ce qu'**il comporte une couche d'encapsulation (5) agencée sur l'organe de support (2) de manière à encapsuler l'ensemble (E) de couches thermoélectriques, la couche d'encapsulation (5) étant de préférence réalisée dans un matériau à base d'un polymère.

4. Capteur (1) selon la revendication 1 ou 2, **caractérisé en ce qu'**il comporte un boîtier (6) de circuit intégré renfermant l'ensemble (E) de couches thermoélectriques, le boîtier (6) de circuit intégré comportant l'organe de support (2), et **en ce que** le boîtier externe (8) renferme le boîtier (6) de circuit intégré.

5. Capteur (1) selon la revendication 4, **caractérisé en ce que** le boîtier (6) de circuit intégré comporte au moins une broche de connexion (32) électrique, et **en ce que** le boîtier externe (8) comporte au moins une piste électrique (90) s'étendant à partir de la broche de connexion (32) électrique.

6. Capteur (1) selon la revendication 4 ou 5, **caractérisé en ce que** le boîtier externe (8) comporte un organe de support (9) agencé pour supporter le boîtier (6) de circuit intégré.

7. Capteur (1) selon l'une des revendications 1 à 6, **caractérisé en ce que** les premiers et les deuxièmes moyens de connexion métalliques comportent une bille de brasage (20, 21) brasée respectivement sur le ou chaque premier plot de connexion (50) et sur le ou chaque deuxième plot de connexion (51) de manière à assembler le substrat (3) et l'organe de support (2).

8. Capteur (1) selon l'une des revendications 1 à 7, **caractérisé en ce que** les premiers et les deuxièmes moyens de connexion métalliques comportent un fil de câblage soudé respectivement sur le ou chaque premier plot de connexion (50) et sur le ou chaque deuxième plot de connexion (51) de manière à assembler le substrat (3) et l'organe de support (2).

9. Capteur (1) selon l'une des revendications 1 à 8, **caractérisé en ce que** les moyens de transfert thermique comportent :

    - au moins une première piste métallique (40) reliant les premiers moyens de connexion à la ou chaque première broche de connexion (30) métallique,
    - au moins une deuxième piste métallique (41) reliant les deuxièmes moyens de connexion à la ou chaque deuxième broche de connexion (31) métallique.

10. Capteur (1) selon l'une des revendications 1 à 9, **caractérisé en ce que** l'ensemble (E) de couches thermoélectriques présente une surface libre ($S_L$), et **en ce que** le capteur (1) comporte un premier et un deuxième éléments thermiquement conducteurs (7a, 7b) s'étendant en regard et à distance de ladite surface libre ($S_L$), et dans le prolongement respectivement du côté chaud et du côté froid dudit ensemble (E).

11. Capteur (1) selon l'une des revendications 1 à 10, **caractérisé en ce qu'**il comporte une couche diélectrique interposée entre le substrat (3) et l'ensemble (E) de couches thermoélectriques.

12. Capteur (1) selon l'une des revendications 1 à 10, **caractérisé en ce que** le substrat (3) est réalisé dans un matériau thermiquement isolant, tel que le verre ou le quartz.

13. Dispositif de mesure différentielle de température, comportant :

    - une pluralité de capteurs (1) selon l'une des revendications 1 à 12,
    - un premier circuit (C1) imprimé, l'organe de support (2) de chaque capteur (1) étant formé sur le premier circuit (C1) imprimé,
    - un deuxième circuit (C2) imprimé agencé en regard du premier circuit imprimé (C1) de sorte que les premier et deuxième circuits (C1, C2) imprimés forment le boîtier externe (8) renfermant l'ensemble (E) de couches thermoélectriques et l'organe de support (2) de chaque capteur (1).

**Patentansprüche**

1. Temperaturdifferenz-Sensor (1) zwischen einer heißen Quelle (Sc) und einer kalten Quelle (Sf), welcher Sensor (1) einen Träger (3), eine auf dem Träger (3) angebrachte Gesamtanordnung (E) von thermoelektrischen Schichten umfasst, wobei die Gesamtanordnung (E) mindestens eine erste Verbindung (10) eines Thermoelements (100, 101) auf einer Seite der Gesamtanordnung (E), heiße Seite genannt, und mindestens eine zweite Verbindung (11) des Thermoelements (100, 101) auf der entgegengesetzten Seite der Gesamtanordnung (E), kalte Seite genannt, aufweist, sowie mindestens ein erstes und ein zweites Anschlussstück (50, 51) umfasst, die dazu vorgesehen sind, Wärme an jede erste Verbindung (10) bzw. jede zweite Verbindung (11) zu übertragen,

**dadurch gekennzeichnet,**
**dass** er umfasst:

- ein wärmeisolierendes Tragteil (2), das dazu vorgesehen ist, den Träger (3) zu tragen, wobei das Tragteil (2) mindestens einen ersten und einen zweiten Anschlussstift (30, 31) aus Metall aufweist,
- erste und zweite Anschlussmittel aus Metall, die dazu vorgesehen sind, das Tragteil (2) mit dem oder jedem ersten Anschlussstück (50) bzw. dem oder jedem zweiten Anschlussstück (51) elektrisch zu verbinden,
- ein Außengehäuse (8), das die Gesamtanordnung (E) thermo-elektrischer Schichten und das Tragteil (2) umschließt, wobei das Außengehäuse (8) eine erste Seite (8a) und eine zweite, entgegengesetzt liegende Seite (8b) aufweist, die dazu vorgesehen sind, mit der heißen Quelle (Sc) bzw. der kalten Quelle (Sf) verbunden zu werden, wobei eine erste Führungsbahn (80) die erste Seite (8a) mit jedem ersten Anschlussstift (30) verbindet, wobei eine zweite Führungsbahn (81) die zweite Seite (8b) mit jedem zweiten Anschlussstift (31) verbindet,

**und dass** das Tragteil (2) Wärmeübertragungsmittel aufweist, die dazu vorgesehen sind, die Wärme von jedem Anschlussstift (30) an die ersten Anschlussmittel aus Metall zu übertragen, und die Wärme von den zweiten Anschlussmitteln aus Metall an jeden zweiten Anschlussstift (31) zu übertragen.

2.    Sensor (1) nach Anspruch 1,

**dadurch gekennzeichnet,**
**dass** die erste und die zweite Seite (8a, 8b) des Außengehäuses (8) mit einem wärmeleitenden Material beschichtet sind.

3.    Sensor (1) nach Anspruch 1 oder 2,

**dadurch gekennzeichnet,**
**dass** er eine Kapselungsschicht (5) aufweist, die auf dem Tragteil (2) dergestalt ausgeführt ist, dass sie die Gesamtanordnung (E) thermo-elektrischer Schichten einkapselt, wobei die Kapselungsschicht (5) vorzugsweise aus einem Werkstoff auf Basis eines Polymers hergestellt ist.

4.    Sensor (1) nach Anspruch 1 oder 2,

**dadurch gekennzeichnet,**
**dass** er ein Gehäuse (6) eines integrierten Schaltkreises aufweist, das die Gesamtanordnung (E) thermo-elektrischer Schichten umschließt, wobei das Gehäuse (6) eines integrierten Schaltkreises das Tragteil (2) enthält, und dass das Außengehäuse (8) das Gehäuse (6) eines integrierten Schaltkreises umschließt.

5.    Sensor (1) nach Anspruch 4,

**dadurch gekennzeichnet,**
**dass** das Gehäuse (6) eines integrierten Schaltkreises mindestens einen elektrischen Anschlussstift (32) aufweist, und dass das Außengehäuse (8) mindestens eine elektrische Bahn (90) enthält, die sich von dem elektrischen Anschlussstift (32) aus erstreckt.

6.    Sensor (1) nach Anspruch 4 oder 5,

**dadurch gekennzeichnet,**
**dass** das Außengehäuse (8) ein Halteorgan (9) enthält, das dazu bestimmt ist, das Gehäuse (6) eines integrierten Schaltkreises zu halten.

7.    Sensor (1) nach einem der Ansprüche 1 bis 6,

**dadurch gekennzeichnet,**
**dass** die ersten und zweiten Anschlussmittel aus Metall ein Lötkügelchen (20, 21) aufweisen, das an dem oder jedem ersten Anschlussstück (50) bzw. dem oder jedem zweiten Anschlussstück (51) dergestalt angelötet wird, dass der Träger (3) und das Tragteil (2) miteinander verbunden werden.

8.    Sensor (1) nach einem der Ansprüche 1 bis 7,

**dadurch gekennzeichnet,**
**dass** die ersten und zweiten Anschlussmittel aus Metall einen Verkabelungsdraht umfassen, der mit dem oder jedem ersten Anschlussstück (50) bzw. dem oder jedem zweiten Anschlussstück (51) dergestalt verschweißt ist, dass der Träger (3) und das Tragteil (2) miteinander verbunden sind.

9.    Sensor (1) nach einem der Ansprüche 1 bis 8,

**dadurch gekennzeichnet,**
**dass** die Wärmeübertragungsmittel umfassen:

- mindestens eine erste metallene Bahn (40), die die ersten Anschlussmittel mit dem oder jedem Anschlussstift (30) aus Metall verbindet,
- mindestens eine zweite metallene Bahn (41), die die zweiten Anschlussmittel mit dem oder jedem Anschlussstift (31) aus Metall verbindet.

10. Sensor (1) nach einem der Ansprüche 1 bis 9,

**dadurch gekennzeichnet,**
**dass** die Gesamtanordnung (E) thermo-elektrischer Schichten eine freie Oberfläche ($S_L$) aufweist, und dass der Sensor (1) ein erstes und ein zweites wärmeleitendes Element (7a, 7b) enthält, welche sich gegenüber und in Abstand zu dieser freien Oberfläche ($S_L$) sowie in der Verlängerung der heißen Seite bzw. der kalten Seite dieser Gesamtanordnung (E) erstrecken.

11. Sensor (1) nach einem der Ansprüche 1 bis 10,

**dadurch gekennzeichnet,**
**dass** er eine elektrisch nicht leitende Schicht aufweist, die zwischen dem Träger (3) und der Gesamtanordnung (E) thermo-elektrischer Schichten angeordnet ist.

12. Sensor (1) nach einem der Ansprüche 1 bis 10,

**dadurch gekennzeichnet,**
**dass** der Träger (3) aus einem wärmeisolierenden Material wie z. B. Glas oder Quarz hergestellt ist.

13. Vorrichtung zur Temperaturdifferenzmessung, welche aufweist:

- eine Mehrzahl von Sensoren (1) nach einem der Ansprüche 1 bis 12,
- eine erste gedruckte Schaltung (C1), wobei das Tragteil (2) jedes Sensors (1) auf der ersten gedruckten Schaltung (C1) ausgeführt ist,
- eine zweite gedruckte Schaltung (C2), die dergestalt gegenüber der ersten gedruckten Schaltung (C1) angeordnet ist, dass die erste und die zweite gedruckte Schaltung (C1, C2) das Außengehäuse (8) bilden, das die Gesamtanordnung (E) thermo-elektrischer Schichten und das Tragteil (2) jedes Sensors (1) umschließt.

**Claims**

1. Differential temperature sensor (1) between a hot source (Sc) and a cold source (Sf), the sensor (1) comprising a substrate (3), an assembly (E) of thermoelectric layers arranged on the substrate (3), the assembly (E) comprising at least one first junction (10) of a thermocouple (100, 101) on one side of the assembly (E), called hot side, and at least one second junction (11) of the thermocouple (100, 101) on the opposite side of the assembly (E), called cold side, at least one first and one second connection pads (50, 51) arranged to transfer heat respectively to each first junction (10) and to each second junction (11), the sensor being **characterized in that** it comprises:

- a thermally-insulating support member (2) arranged to support the substrate (3), the support member (2) comprising at least one first and one second metal connector pins (30, 31),
- first and second metal connection means arranged to electrically connect the support member (2) respectively to the or each first connection pad (50) and to the or each second connection pad (51),
- an external package (8) enclosing the assembly (E) of thermoelectric layers and the support member (2), the external package (8) comprising a first surface (8a) and a second opposite surface (8b) intended to be respectively connected to the hot source (Sc) and to the cold source (Sf), a first via (80) connecting the first surface (8a) to each first connector pin (30), a second via (81) connecting the second surface (8b) to each second connector pin (31), and **in that** the support member (2) comprises heat transfer means arranged to transfer heat from each first connector pin (30) to the first metal connection means, and to transfer heat from the second metal connection means to each second connector pin (31).

2. Sensor (1) according to claim 1, **characterized in that** the first and second surfaces (8a, 8b) of the external package (8) are coated with a thermally-conductive material.

3. Sensor (1) according to claim 1 or 2, **characterized in that** it comprises an encapsulation layer (5) arranged on the support member (2) to encapsulate the assembly (E) of thermoelectric layers, the encapsulation layer (5) being preferably made of a polymer- based material.

4. Sensor (1) according to claim 1 or 2, **characterized in that** it comprises an integrated circuit package (6) enclosing the assembly (E) of thermoelectric layers, the integrated circuit package (6) comprising the support member (2), and **in that** the external package (8) encloses the integrated circuit package (6).

5. Sensor (1) according to claim 4, **characterized in that** the integrated circuit package (6) comprises at least one electric connector pin (32) and **in that** the external package (8) comprises at least one electric track (90) extending from the electric connector pin (32).

6. Sensor (1) according to claim 4 or 5, **characterized**

**in that** the external package (8) comprises a support member (9) arranged to support the integrated circuit package (6).

7. Sensor (1) according to any of claims 1 to 6, **characterized in that** the first and the second metal connection means comprise a solder bump (20, 21) respectively soldered onto the or each first connection pad (50) and onto the or each second connection pad (51) to assemble the substrate (3) and the support member (2).

8. Sensor (1) according to any of claims 1 to 7, **characterized in that** the first and the second metal connection means comprise a bonding wire respectively welded onto the or each first connection pad (50) and onto the or each second connection pad (51) to assemble the substrate (3) and the support member (2).

9. Sensor (1) according to any of claims 1 to 8, **characterized in that** the heat transfer means comprise:

   - at least one first metal track (40) connecting the first connection means to the or each first metal connector pin (30),
   - at least one second metal track (41) connecting the second connection means to the or each second metal connector pin (31).

10. Sensor (1) according to any of claims 1 to 9, **characterized in that** the assembly (E) of thermoelectric layers has a free surface ($S_L$), and **in that** the sensor (1) comprises a first and a second thermally-conductive elements (7a, 7b) facing said free surface ($S_L$) and extending at a distance from said free surface ($S_L$), and respectively continuing said assembly (E) on the hot side and on the cold side.

11. Sensor (1) according to any of claims 1 to 10, **characterized in that** it comprises a dielectric layer interposed between the substrate (3) and the assembly (E) of thermoelectric layers.

12. Sensor (1) according to any of claims 1 to 10, **characterized in that** the substrate (3) is made of a thermally-insulating material, such as glass or quartz.

13. Differential temperature measurement device, comprising:

   - a plurality of sensors (1) according to any of claims 1 to 12,
   - a first printed circuit (C1), the support member (2) of each sensor (1) being formed on the first printed circuit (C1),
   - a second printed circuit (C2) arranged opposite the first printed circuit (C1) so that the first and second printed circuits (C1, C2) form the external package (8) enclosing the assembly (E) of thermoelectric layers and the support member (2) of each sensor (1).

**Fig. 1**

**Fig. 2**

Fig. 3

Fig. 4

Fig. 5

Fig. 6

Fig. 7

Fig. 8

Fig. 9

Fig. 10

Fig. 11a

Fig. 11b

Fig. 11c

Fig. 12a

Fig. 12b

Fig. 12c

Fig. 13a

Fig. 13b

Fig. 13c

Fig. 14a

Fig. 14b

Fig. 14c

Fig. 15a

Fig. 15b

Fig. 15c

Fig. 16a    Fig. 16b    Fig. 16c

Fig. 17a    Fig. 17b    Fig. 17c

Fig. 18a    Fig. 18b    Fig. 18c

Fig. 19a    Fig. 19b    Fig. 19c

Fig. 20a    Fig. 20b    Fig. 20c

Fig. 21a

Fig. 21b

Fig. 21c

Fig. 22a

Fig. 22b

Fig. 22c

Fig. 23a

Fig. 23b

Fig. 23c

Fig. 24

Fig. 25

Fig. 26

**RÉFÉRENCES CITÉES DANS LA DESCRIPTION**

**Documents brevets cités dans la description**

- WO 2007034048 A
- FR 2955708
- WO 8402037 A
- FR 2598803
- WO 2011012586 A

**Littérature non-brevet citée dans la description**

- **SEOK HWAN OH et al.** Micro heat flux sensor using copper electroplating in SU-8 microstructures. *Journal of Micromechanics and Microengineering,* 2001, vol. 11, 221-225